# EUROPÄISCHE PATENTSCHRIFT

(11) **EP 3 617 734 B1**
(45) Veröffentlichungstag und Bekanntmachung des Hinweises auf die Patenterteilung: **09.10.2024**
(21) Anmeldenummer: 18191075.3
(22) Anmeldetag: 28.08.2018
(51) Int. Cl.: G01R 33/565, G01R 33/56

(54) **VERFAHREN ZUR KOMPENSIERUNG VON WIRBELSTRÖMEN WÄHREND DER AUSGABE EINES SÄTTIGUNGSPULSES BEI DER AUFNAHME VON KERNSPINRESONANZDATEN**
METHOD FOR COMPENSATING EDDY CURRENTS DURING THE APPLICATION OF A SATURATION PULSE IN A NUCLEAR MAGNETIC RESONANCE DATA ACQUISITION
PROCÉDÉ DE COMPENSATION DE COURANTS DE FOUCAULT PENDANT L'APPLICATION D'UNE IMPULSION DE SATURATION DANS UNE ACQUISITION DE DONNÉS DE RÉSONANCE MAGNÉTIQUE NUCLÉAIRE

(43) Veröffentlichungstag der Anmeldung: 04.03.2020
(73) Patentinhaber: Siemens Healthineers AG, 91301 Forchheim (DE)
(72) Erfinder: Hölscher, Uvo, 91052 Erlangen (DE); Köhler, Michael, 90408 Nürnberg (DE); Niederlöhner, Daniel, 91054 Erlangen (DE); Stemmer, Alto, 91054 Erlangen (DE)
(74) Vertreter: Siemens Healthineers Patent Attorneys

(56) Entgegenhaltungen:
- US-A1- 2010 148 774
- FRANZ SCHMITT: "The Gradient System", PROCEEDINGS OF THE INTERNATIONAL SOCIETY FOR MAGNETIC RESONANCE IN MEDICINE, ISMRM, 21ST ANNUAL MEETING AND EXHIBITION, SALT LAKE CITY, UTAH, USA, 20-26 APRIL 2013, 7 April 2013 (2013-04-07), XP040632498

## Beschreibung

Die Erfindung betrifft ein Verfahren zum Betrieb einer Magnetresonanzeinrichtung bei der Aufnahme von Magnetresonanzdaten mittels einer Magnetresonanzsequenz, die wenigstens ein Sättigungsmodul für eine zu sättigende Spinart, in dem ein Hochfrequenz-Sättigungspuls zwischen einem ersten und einem zweiten Spoilergradientenpuls ausgegeben wird, und neben den Spoilergradientenpulsen mehrere weitere Gradientenpulse umfasst. Daneben betrifft die Erfindung eine Magnetresonanzeinrichtung, ein Computerprogramm und einen elektronisch lesbaren Datenträger.

Magnetresonanzeinrichtungen sind eine insbesondere im medizinischen Bereich inzwischen etablierte Bildgebungsmodalität. Eines der die Bildqualität in der Magnetresonanzbildgebung beeinflussenden Probleme sind beim Ausspielen von Magnetresonanzsequenzen auftretende Wirbelströme. Wirbelströme entstehen, wenn sich ein Magnetfeld zeitlich ändert, beispielsweise also ein Gradient ein- oder ausgeschaltet wird. Diese zeitliche Änderung des Magnetfeldes induziert einen Strom in einer leitenden Struktur einer Komponente der Magnetresonanzeinrichtung. Die induzierten Wirbelströme erzeugen ihrerseits selbst ein Magnetfeld, nämlich ein Wirbelstromfeld, das sich mit den bereits bestehenden Magnetfeldern überlagert. Nachdem die Magnetresonanzbildgebung kleine Effekte misst und somit stark von einer guten Kontrolle über die bestehenden Magnetfelder abhängt, beispielsweise hinsichtlich der Homogenität des Grundmagnetfeldes und der Linearität der Gradientenfelder, sind jegliche zusätzliche auftretenden Magnetfelder, also auch die Wirbelstromfelder, ein Problem für die Bildqualität. Je nach der Geometrie der sich ändernden Magnetfelder und der leitenden Strukturen können die Wirbelstromfelder unterschiedliche räumliche Verteilungen aufweisen.

Wirbelströme klingen üblicherweise mit einer Exponentialfunktion ab. Die Zeitkonstante des Zerfalls des Wirbelstroms ist dabei durch die Materialeigenschaften der leitenden Struktur, vor allem ihre Leitfähigkeit, bestimmt. Werden die Wirbelströme von verschiedenen Gradientenfeldern, beispielsweise im Fall von X-, Y- und Z-Gradientenspulen, in verschiedenen leitenden Strukturen induziert, so entsteht eine Superposition der einzelnen Wirbelstromfelder. Dieses resultierende Gesamtwirbelstromfeld kann mehrere Zeitkonstanten besitzen und komplexe räumliche Verteilungen aufweisen.

Es existieren zwei grundsätzliche Ansätze, um die Auswirkungen von Wirbelströmen zu vermeiden bzw. wenigstens zu reduzieren. Zunächst ist es möglich, abzuwarten, bis die Wirbelströme abgeklungen sind, zum anderen kann ein Magnetfeld geschaltet werden, das entgegengesetzte Wirbelströme erzeugt. Diese beiden Ansätze werden in vielen verschiedenen Ausprägungen bei heutigen Magnetresonanzeinrichtungen eingesetzt.

In der Magnetresonanzbildung sind bereits verschiedene Verfahren bekannt geworden, um die Signale bestimmter Spinarten auszublenden, mithin zu sättigen. Dabei wird insbesondere ausgenutzt, dass unterschiedlich gebundene Protonen leicht unterschiedliche Resonanzfrequenzen aufweisen, was auch als chemische Verschiebung bezeichnet wird. Die meist eingesetzte Art der Sättigung betrifft die Spins von in Fett gebundenen Protonen als Spinart, kurz die sogenannte Fettsättigung. Dabei sollen die Magnetresonanzsignale von Fettgewebe im menschlichen Körper unterdrückt werden. Dabei macht man sich die chemische Verschiebung zu Nutze, wonach Spins in Fettmolekülen eine leicht andere Resonanzfrequenz aufweisen als Spins in Wassermolekülen. Mithin ist es möglich, Hochfrequenzpulse auszuspielen, die nur die Spins in Fettmolekülen ("Fettspins") und nicht die Spins in Wassermolekülen ("Wasserspins") beeinflussen. Derartige Hochfrequenzpulse werden auch als spektral selektive Pulse bezeichnet.

Eine wesentliche Voraussetzung für derartige Sättigungsmethoden ist, dass die Grundhomogenität des Grundmagnetfeldes (B0-Feldes) deutlich besser ist als die chemische Verschiebung zwischen den Resonanzfrequenzen. So beträgt für Wasser und Fett bei 1,5 Tesla die Frequenzdifferenz ca. 210 Hertz, so dass man für eine effektive Fettsättigung eine B0-Homogenität benötigt, die deutlich besser als 210 Hertz ist. Gilt dies nicht, können beispielsweise Wasserspins an einigen Stellen dieselbe Resonanzfrequenz wie Fettspins besitzen, wenn das Grundmagnetfeld kleiner ist. Dann beeinflusst eine spektralselektive Anregung nicht nur Fettspins, sondern auch Wasserspins. Denkbar ist es bei einer Erhöhung des Grundmagnetfeldes im Übrigen auch, dass die spektralselektiven Pulse weder Fettspins noch Wasserspins betreffen.

Beide aufgrund von Inhomogenitäten auftretenden Fehlerfälle sind für die klinische Bildgebung mit Fettsättigung problematisch, da Signal von Wasserspins verschwinden und Signal von Fettspins erhalten bleiben kann. Nachdem entsprechende Inhomogenitäten auch durch Wirbelstromfelder entstehen können, sind die Wirbelströme auch bezüglich der Fettsättigung relevant. Durch die räumliche Variation der Wirbelströme bzw. der Wirbelstromfelder treten Inhomogenitäten meist lokal auf, beispielsweise am Rand des Messbereiches. Jedoch können vor allem lokale Vorkommnisse als Pathologien fehlinterpretiert werden, da die Fettsättigung ja grundsätzlich funktioniert und nur in einigen, lokal begrenzten Bereichen fehlschlägt.

Ein Verfahren und eine zugehörige Vorrichtung mit einer Kompensationseinheit zur Kompensation eines verbleibenden magnetischen Feldes, welches durch Wirbelströme aufgrund von Gradientenpulsen entsteht, zum Zeitpunkt der Ausgabe von Prä-Pulsen wird beispielsweise in der US 2010/148774 A1 beschrieben.

Wirbelströme und hierdurch entstehende Wirbelstromfelder spielen auch eine große Rolle bei EPI-Sequenzen als Magnetresonanzsequenzen, wobei EPI für "Echo Planar Imaging" steht. Besonders zu nennen ist hier die Diffusions-EPI-Bildgebung. Nachdem starke Gradientenfelder durch entsprechende Gradientenpulse schnell geschaltet werden, ist die EPI-Bildgebung besonders anfällig für Wirbelströme. Die Auswirkungen von Wirbelströmen in der Diffusions-EPI-Bildgebung sind vielgestaltig. So kann es zu Verzerrungen des entstehenden Magnetresonanzbildes, zum Verlust von Magnetresonanzsignalen und zu einer Verschlechterung der Fettsättigung kommen. Eine weitere Besonderheit der Diffusions-EPI-Sequenz ist, dass sich über die gesamte Messung die Wirbelströme stark ändern. Andere Magnetresonanzsequenzen, wie beispielswese TSE-Sequenzen (Turbo-Spin-Echo-Sequenzen) oder GRE-Sequenzen (Gradientenecho-Sequenzen) spielen nach jeder Anregung der Spins relativ ähnliche Gradientenpulse aus, beispielsweise Schichtselektions-Gradientenpulse und Auslese-Gradientenpulse, die gleichbleiben, nachdem sich nur die Phasencodier-Gradientenpulse ändern. Bei einer Diffusions-EPI-Sequenz sind zwar die Gradientenpulse für die Bildaufnahme auch sehr ähnlich, es werden jedoch wechselnde Diffusionsgradientenpulse benutzt. Diese Diffusionsgradientenpulse variieren in Stärke und Richtung der Gradientenfelder äußerst stark, so dass ihre Wirbelströme auch während der Messung besonders stark variieren.

Für Diffusions-EPI-Sequenzen wurden bereits Kompensationsverfahren hinsichtlich der Wirbelströme vorgeschlagen, die sich auf Aspekte der Bildgebung konzentrieren, beispielsweise bipolare Diffusionsgradienten, Vorverzerrung von Gradientenpulsen und eine Registrierung von Magnetresonanzbildern in der Nachbearbeitung.

Sättigungsmodule in der Magnetresonanzsequenz wurden dabei bislang noch nicht weiter beachtet, insbesondere im Hinblick auf die Fettsättigung bei der Diffusionsbildgebung. Der Grund hierfür ist, dass Diffusionsbildgebung meist im Hinblick auf Anwendungen im Kopfbereich des Patienten bzw. neurologische Fragestellungen angewendet wurde. Denn in diesem Kontext werden üblicherweise kleine Untersuchungsbereiche im Zentrum der Magnetresonanzeinrichtung und somit des Homogenitätsvolumens eingesetzt, in denen die Wirbelstromfelder noch klein genug sind, so dass die Homogenität wenig beeinflusst wird. Für die immer häufiger eingesetzte Ganzkörper-Bildgebung bzw. Torso-Bildgebung, sind jedoch größere Untersuchungsbereiche zu wählen, bei denen auch Störungen der Sättigungsverfahren durch Wirbelströme relevant werden können. Bislang wird diesbezüglich meist eine Umgehungslösung eingesetzt, indem Sättigungsmethoden eingesetzt werden, die nicht die chemische Verschiebung ausnutzen. Ein Beispiel hierfür ist die STIR-Methode (Short-Tau Inversion Recovery), die auf Inversionspulsen basiert. Diese Sättigungsmethoden benötigen jedoch eine längere Untersuchungszeit und weisen eine höhere SAR-Belastung (Belastung durch absorbierte Energie der Hochfrequenzstrahlung) für den Patienten auf, was gegebenenfalls die Gesamtmesszeit noch zusätzlich verlängert, da Wartepausen eingefügt werden müssen. Ferner reduziert die Verwendung von STIR im Allgemeinen das Signal-zu-Rausch-Verhältnis.

Der Erfindung liegt daher die Aufgabe zugrunde, für spektral selektive Hochfrequenz-Sättigungspulse nutzende Sättigungsmethoden die Beeinflussung der Sättigungsqualität durch Wirbelströme zu reduzieren.

Diese Aufgabe wird erfindungsgemäß gelöst durch ein Verfahren, eine Magnetresonanzeinrichtung, ein Computerprogramm und einen elektronisch lesbaren Datenträger gemäß den unabhängigen Ansprüchen. Vorteilhafter Ausgestaltungen ergeben sich aus den abhängigen Ansprüchen.

Ein Verfahren der eingangs genannten Art umfasst demnach die folgenden Schritte:
- es werden während der Ausgabe des Sättigungpulses vorliegende Wirbelströme aufgrund der weiteren Gradientenpulse beschreibende Wirbelstromdaten ermittelt,
- in Abhängigkeit der Wirbelstromdaten wird wenigstens ein Pulsparameter des ersten Spoilergradientenpulses zur Kompensation wenigstens eines Teils der durch die Wirbelstromdaten beschriebenen Wirbelströme durch mittels des ersten Spoilergradientenpulses erzeugte Wirbelströme wenigstens während der Ausgabe des Sättigungspulses gewählt, und
- der erste Spoilergradientenpuls wird mit dem wenigstens einen gewählten Pulsparameter ausgegeben.

Dabei wird in Abhängigkeit des gewählten Pulsparameters des ersten Spoilergradientenpulses auch wenigstens ein Pulsparameter des zweiten Spoilergradientenpulses eines vorangehenden Sättigungsmoduls angepasst.

Damit wird es ermöglicht, auch bei großen Aufnahmebereichen, wie beispielsweise in der Ganzkörper-Bildgebung und/oder der Torso-Bildgebung, die Beeinflussung der Sättigung, insbesondere der Fettsättigung bei Spins von in Fett gebundenen Protonen als Spinart, durch Wirbelstromfelder zu reduzieren. Dabei wird ausgenutzt, dass die spektral selektiven Hochfrequenz-Sättigungspulse in dem Sättigungsmodul gemeinsam mit Spoilergradientenpulsen ausgespielt werden. Der dem spektral selektiven Sättigungspuls nachfolgende, zweite Spoilergradientenpuls dephasiert die in die Transversalebene gekippten Spins der Spinart, insbesondere die Fettspins. Üblich ist es zudem, unmittelbar vor dem Sättigungspuls einen Spoilergradientenpuls auszugeben, der zumindest im Wesentlichen das negative Moment des Spoilergradientenpulses nach dem Sättigungspuls hat. Dieser erste Spoilergradientenpuls des Sättigungsmoduls sorgt bei schnellen Repetitionen des Sättigungsmoduls und somit des Sättigungspulses dafür, dass zum Start des Sättigungspulses die Spins der zu sättigenden Spinart, insbesondere die Fettspins, rephasiert sind und somit keine verbleibende Spinart-Magnetisierung verbleibt. Mit anderen Worten sollen hierdurch stimulierte Echos und/oder rephasierte Magnetisierungspfade vermieden werden.

Die grundlegende Idee der vorliegenden Erfindung ist es nun, den ersten Spoilergradientenpuls, der vor dem Sättigungspuls ausgegeben wird, in wenigstens einem Pulsparameter derart auf die aktuell vorliegenden Wirbelströme der Magnetresonanzsequenz abzustimmen, dass diese wenigstens teilweise kompensiert werden. Dabei wird der wenigstens eine Pulsparameter bevorzugt aus der Gruppe umfassend die Pulsform bestimmende Pulsparameter, die Polarität und die verwendeten Gradientenrichtungen gewählt. Was die Pulsform angeht, hat sich gezeigt, dass als Pulsparameter hier hauptsächlich die Amplitude des ersten Spoilergradientenpulses relevant ist, nachdem vorliegend Wirbelströme mit langer Zeitkonstante betrachtet werden, die hauptsächlich durch die Fläche unter der Pulsform beeinflusst sind. Dabei sind jedoch auch andere Pulsparameter denkbar, beispielsweise die Slew Rate, die angepasst werden können. Besonders bevorzugt ist es im Rahmen der vorliegenden Erfindung jedoch, die Amplitude als Pulsparameter heranzuziehen, nachdem diese hauptsächlich das Integral über die Pulsform und somit die Fläche beeinflusst. Ein weiterer, besonders vorteilhaft im Rahmen der vorliegenden Erfindung eingesetzter Freiheitsgrad ist die Tatsache, dass die Spoilergradientenpulse bislang auf einer beliebigen Gradientenachse, beispielsweise als X-Gradienten, Y-Gradienten oder Z-Gradienten, ausgespielt werden, da ihre Aufgabe rein die Dephasierung der Spins der Spinart ist. Vorgeschlagen wurde auch, die Spoilergradientenpulse auf allen drei Gradientenachsen auszuspielen, um die Last der Gradientenverstärker (GPA) zu verteilen. Für die reine Aufgabenstellung der Dephasierung bzw. Rephasierung ist es aber grundsätzlich irrelevant, welche Richtung für die Spoilergradientenpulse gewählt wird, insbesondere welche der drei Hauptrichtungen (Gradientenachsen), für die eine Gradientenspule in der Gradientenspulenanordnung vorliegt, dies geschieht.

Soll der erste Spoilergradientenpuls zur Kompensation der Wirbelströme genutzt werden, kann also mit besonderem Vorteil die Amplitude und die Verteilung auf die Gradientenachsen, mithin die Gradientenrichtung, dynamisch während der Messung variiert werden, jeweils in Abhängigkeit von den durch die vorangehenden weiteren Gradientenpulse erzeugten Wirbelströmen. Denn auch die Rampen der Spoilergradientenpulse erzeugen Wirbelströme, die den Wirbelströmen, die durch das Schalten der weiteren Gradientenpulse in vorangegangenen Modulen erzeugt worden sind, entgegenwirken können. Dazu werden also zu jedem Zeitpunkt, an dem ein Sättigungspuls ausgespielt werden soll, Wirbelstromdaten ermittelt, die die Wirbelströme der vorherigen Gradientenpulse beschreiben. In der Praxis zeigt sich, dass dies vor allem die Wirbelströme der vorher vermessenen Schicht bzw. der vorherigen Repetition betrifft, wobei bei Zeitkonstanten der Wirbelströme, die länger als die Messdauer einer Schicht sind, auch weitere Gradientenpulse mehrerer früherer Schichten relevant sein können. Dabei wird ausgenutzt, dass sich die Wirbelstromdaten sehr genau bestimmen lassen, denn die Gradientenverläufe sind für die gesamte Untersuchung, mithin die gesamte Messdauer, im Voraus bekannt. Insbesondere können die Stärken und Zeitkonstanten der induzierten Wirbelströme in einem einmaligen Kalibrierungsschritt bestimmt werden, nachdem sie nicht oder zumindest nicht auf relevante Art vom aktuellen Patienten abhängen, worauf im Folgenden noch näher eingegangen werden wird.

Liegen die Wirbelstromdaten vor, können Pulsparameter des ersten Spoilergradientenpulses optimiert werden, insbesondere die Amplitude, die Polarität und die Nutzung der Gradientenachsen/Hauptrichtungen. Somit ist es möglich, einen Spoilergradientenpuls dahingehend zu designen, dass dessen Wirbelstromfelder den bestehenden Wirbelstromfeldern entgegengesetzt sind.

Mithin wird erfindungsgemäß ein bislang nur für die Sättigung benutzter Spoilergradientenpuls nun ebenso für die Kompensation der Wirbelströme bzw. Wirbelstromfelder genutzt. Dabei hat sich gezeigt, dass der erste Spoilergradientenpuls so modifiziert werden kann, dass er weiterhin mit kleinen Einbußen seinen bisherigen Zweck erfüllt, zusätzlich aber auch das Problem adressiert, dass eine Sättigung in einigen Unterbereichen des Untersuchungsbereichs aufgrund von Wirbelströmen fehlschlagen kann. Dabei kann bevorzugt ausgenutzt werden, dass die Wahl der Gradientenachsen, auf denen der erste Spoilergradientenpuls ausgespielt wird, und die Amplitude innerhalb gewisser Grenzen stark variiert werden kann, wobei die ursprüngliche Aufgabe des ersten Spoilergradientenpulses weiterhin erfüllt wird.

Hieraus ergeben sich deutliche Vorteile gegenüber anderen Maßnahmen, beispielsweise zusätzlichen Kompensationsgradienten, bipolaren Diffusionsschemata und/oder Wartepausen. Das hier vorgestellte Verfahren benötigt keine zusätzliche Messzeit, da die Dauern der ersten Spoilergradientenpulse schon fester Bestandteil des gesamten Zeitablaufs sind. Mit anderen Worten werden die Echozeit TE und die Repetitionszeit TR nicht beeinflusst.

Weiter ist es von Vorteil, dass dadurch, dass bereits vorhandene Gradientenpulse für einen zweiten Zweck genutzt werden, keine oder nur geringe zusätzliche Leistungen für die Gradientenverstärker bzw. das komplette Gradientensystem benötigt wird. Dies ist insbesondere für Diffusions-EPI-Sequenzen recht wichtig, da viele Messprotokolle mit EPI-Diffusions-Sequenzen durch die elektrische Leistung der Gradientenverstärker oder die Leistungsfähigkeit der Kühlung der Gradientenspulenanordnung und der Gradientenverstärker limitiert sind.

Dabei lässt sich das vorliegende Verfahren besonders vorteilhaft anwenden, wenn die weiteren Gradientenpulse wenigstens einen Diffusionsgradientenpuls in einem Diffusionsmodul der Magnetresonanzsequenz umfassen und/oder die Magnetresonanzsequenz eine EPI-Sequenz ist. Insbesondere ergeben sich also Vorteile bei der Diffusions-EPI-Bildgebung. Gerade im Fall von verwendeten Diffusionsgradienten ergibt sich das eingangs dargestellte Problem, dass diese in Stärke und Richtung stark variieren, so dass immer unterschiedliche Wirbelströme in den Sättigungsmodulen vorliegen, auf die mittels der vorliegenden Erfindung der erste Spoilergradientenpuls dynamisch von Sättigungsmodul zu Sättigungsmodul angepasst werden kann.

Insbesondere ist es in diesem Kontext vorteilhaft, wenn als Pulsparameter die Polarität des ersten Spoilergradientenpulses des dem Diffusionsmodul nachfolgenden Sättigungsmoduls umgekehrt zu der des wenigstens einen Diffusionsgradientenpulses gewählt wird. Nachdem es bislang häufig so war, dass die Polarität des ersten Spoilergradientenpulses gleich der Polarität der vorangegangenen Diffusionsgradientenpulse gewählt wurde, wird mithin vorgeschlagen, die Wahl der Polarität des Spoilergradientenpulses von der Polarität der Diffusionsgradientenpulse derart abhängig zu machen, dass die entgegengesetzte Polarität zu den Diffusionsgradientenpulsen gegeben ist. Dabei sei an dieser Stelle noch angemerkt, dass das vorhergehende Diffusionsmodul meist das Diffusionsmodul der vorherigen Schichtaufnahme bzw. Repetition sein dürfte, da Sättigungsmodule meist zu Beginn einer Schichtaufnahme bzw. Repetition benutzt werden.

Die Wirbelstromdaten können im Rahmen einer Simulation und/oder unter Verwendung eines mathematischen Zusammenhangs und/oder unter Berücksichtigung vorbekannter, die weiteren Gradientenpulse beschreibender Sequenzdaten und/oder wenigstens einer wenigstens eine Eigenschaft wenigstens einer Komponente der Magnetresonanzeinrichtung bezüglich durch Gradientenpulse induzierter Wirbelströme beschreibenden Komponenteninformation ermittelt werden. Dabei ist hervorzuheben, dass die vorliegende Erfindung hauptsächlich auf eine deutliche Reduzierung der vorliegenden Wirbelstromfelder bei der Ausgabe des Sättigungspulses abzielt, so dass mithin eine vollständige Kompensation aller Wirbelströme bzw. Wirbelstromfelder nicht notwendig ist, mithin es für die Wirbelstromdaten ausreichend ist, eine Abschätzung vorzunehmen. Eine derartige Abschätzung ist jedoch unter Kenntnis der verwendeten Magnetresonanzsequenz bzw. insgesamt des Messprotokolls für die gesamte Untersuchung, die üblicherweise mehrere Repetitionen der Magnetresonanzsequenz enthält, sowie der Wirbelstromursachen, hier abgebildet durch die Komponenteninformationen, die letztlich die leitenden Strukturen, in die Wirbelströme induziert werden können, beschreiben, auf einfache Art und Weise aufgrund von Grundzusammenhängen möglich, so dass sich einfache Simulationen und/oder mathematische Zusammenhänge herleiten lassen, um die Wirbelstromdaten aufwandsarm zu bestimmen, mithin die Wirbelströme und Wirbelstromfelder abzuschätzen.

Bezüglich der Komponenteninformation kann mit besonderem Vorteil vorgesehen sein, dass sie in einem Kalibrierungsvorgang durch Messung mit vordefinierten Kalibrierungsgradientenpulsen ermittelt wird. Dabei oder auch bei anderen, beispielsweise theoretisch basierten Ermittlungen der Komponenteninformation, ist es zweckmäßig, wenn die Komponenteninformation wenigstens eine die Stärke induzierter Wirbelströme beschreibende Stärkegröße und/oder wenigstens eine den Zerfall der Wirbelströme beschreibende Zeitkonstante umfasst, wobei die Zeitkonstante die wesentlichere, entscheidende Größe darstellt. In einer beispielhaften Ausgestaltung ist es mithin denkbar, Pulsparameter auf resultierende Wirbelströme und mithin Wirbelstromfelder abzubilden. Hierbei können beispielsweise gezielte Kalibrierungsvorgänge durchgeführt werden, indem in einer Kalibrierungsmessung Gradientenpulse definierter Pulsparameter auf den verschiedenen Gradientenachsen ausgegeben werden, denen jeweils eine Gradientenspule der Gradientenspulenanordnung zugeordnet ist, so dass auf allgemeine Abhängigkeiten gefolgert werden kann und somit unter Kenntnis der im Rahmen der Untersuchung verwendeten Pulsparameter der weiteren Gradientenpulse die Wirbelstromdaten leicht ermittelt werden können.

Die Ermittlung des wenigstens einen Pulsparameters kann in einem auf die Minimierung verbleibender Wirbelströme abzielenden Optimierungsverfahren und/oder aufgrund wenigstens eines mathematischen Zusammenhangs und/oder unter Verwendung wenigstens einer Randbedingung erfolgen. Insbesondere im Hinblick darauf, dass es um eine qualitative deutliche Verringerung der Wirbelströme und somit Wirbelstromfelder gehen soll, mithin keine exakte Auslöschung, kann auch im Zusammenhang der Ermittlung der angepassten Pulsparameter ein mathematischer, hergeleiteter Zusammenhang ausreichend sein. Denkbar ist es jedoch selbstverständlich auch, ein Optimierungsverfahren einzusetzen, insbesondere dann, wenn weitere Aspekte, die sich nicht einfach in mathematischen Zusammenhängen abbilden lassen, berücksichtigt werden sollen, insbesondere auch bestimmte Randbedingungen.

In diesem Kontext sieht eine besonders vorteilhafte Weiterbildung der vorliegenden Erfindung vor, dass als Randbedingung wenigstens ein minimales Gesamtmoment des ersten Spoilergradientenpulses und/oder eine maximale Amplitude des ersten Spoilergradientenpulses und/oder eine maximale Slew Rate des ersten Spoilergradientenpulses verwendet werden. Insgesamt können also bei der Ermittlung der Pulsparameter Limitationen, die durch die Magnetresonanzeinrichtung bzw. das Messprotokoll im Allgemeinen und durch die Gradientenspulenanordnung im Speziellen gegeben sind, verwendet werden. Gerade hinsichtlich des Gradientensystems, insbesondere was die Leistungsfähigkeit der Gradientenverstärker und/oder der Gradientenspulen der Gradientenspulenanordnung angeht, existieren meist systemseitig vorgesehene Beschränkungen für Pulsparameter, beispielsweise eine maximale Slew Rate, eine maximale Gradientenamplitude bzw. eine allgemeine Leistungsbeschränkung. Maximale Slew Rates und/oder maximale Gradientenamplituden beziehen sich dabei häufig auf einzelne Gradientenachsen. Eine weitere relevante Randbedingung stellt ein minimales Gesamtmoment dar. Ein minimales Gesamtmoment ist erforderlich für die Dephasierung der Spins der Spinart nach dem Sättigungspuls, also durch den zweiten Spoilergradientenpuls, dessen Effekt ja durch den ersten Spoilergradientenpuls gerade kompensiert werden soll, um die Wirkung des Sättigungspulses zu optimieren.

In diesem Kontext ist es auch besonders vorteilhaft, wenn als weiteres, insbesondere geringer gewichtetes Optimierungsziel und/oder als Randbedingung eine möglichst weitgehende Rephasierung von durch den zweiten Spoilergradientenpuls eines vorangehenden Sättigungsmoduls dephasierten Spins der zu sättigenden Spinart verwendet wird. Der führende Spoilergradientenpuls eines Sättigungsmoduls dient der Rephasierung des dephasierenden zweiten Spoilergradientenpulses des vorherigen Sättigungsmoduls. Durch Modifikationen von Pulsparametern im Hinblick auf die Wirbelstromdaten kann es dazu kommen, dass diese Rephasierung nicht mehr vollständig ist. Für viele Situationen wird dies die Bildqualität nicht signifikant beeinflussen, es kann jedoch Sonderfälle geben, in denen zweckmäßigerweise eine zusätzliche Randbedingung bzw. ein zusätzliches Optimierungsziel diesbezüglich eingeführt werden sollte, um die Bildqualität insgesamt zu verbessern.

Es sei an dieser Stelle bezüglich der Ermittlung des wenigstens einen Pulsparameters noch angemerkt, dass selbstverständlich auch hier die bereits erwähnte Komponenteninformation mitverwendet werden kann, da die Spoilergradientenpulse ja auch über die Gradientenspulen der Gradientenspulenanordnung ausgegeben werden und somit die Komponenteninformation auch bezüglich der Spoilergradientenpulse gilt, mithin auf einfache Art und Weise die kompensierenden Wirbelströme/Wirbelstromfelder ermittelt werden können.

In Abhängigkeit des gewählten Pulsparameters des ersten Spoilergradientenpulses wird wenigstens ein Pulsparameter des zweiten Spoilergradientenpulses eines vorangehenden Sättigungsmoduls angepasst. Führt beispielsweise die Anpassung der Pulsparameter für den ersten Spoilergradientenpuls zu einer Veränderung von dessen Gesamtmoment, das ja rephasierend wirken soll, kann es zweckmäßig sein, das vorangehende Dephasierungsmoment entsprechend anzupassen. Mit anderen Worten kann vorgesehen sein, dass bei einem durch den gewählten Pulsparameter des ersten Spoilergradientenpulses von einem Vorgabemoment abweichenden Rephasierungsmoment der Pulsparameter des zweiten Spoilergradientenpulses des vorangehenden Sättigungsmoduls zur Erzeugung eines dem Rephasierungsmoment entsprechenden Dephasierungsmoments angepasst wird. Dabei ist, wie bereits erwähnt, darauf zu achten, dass ein minimales Dephasierungsmoment in jedem Fall erhalten bleibt, damit der zweite Spoilergradientenpuls seinen Zweck erfüllen kann.

Untersuchungen zur vorliegenden Erfindung haben gezeigt, dass bereits mit einfachen, grob abschätzenden Maßnahmen eine Reduzierung der Wirbelströme und somit der Wirbelstromfelder zum Zeitpunkt des Sättigungspulses auf ca. die Hälfte möglich wurde, ohne dass an anderer Stelle eine Verschlechterung bezüglich der Wirbelströme auftrat, mithin anderweitig die Wirbelstromfelder merkbar verschlechtert wurden.

Neben dem Verfahren betrifft die Erfindung auch eine Magnetresonanzeinrichtung, die eine zur Durchführung des erfindungsgemäßen Verfahrens ausgebildete Steuereinrichtung aufweist. Sämtliche Ausführungen bezüglich des erfindungsgemäßen Verfahrens lassen sich analog auf die erfindungsgemäße Magnetresonanzeinrichtung übertragen, so dass auch mit dieser die bereits genannten Vorteile erhalten werden können. Dabei weist die Magnetresonanzeinrichtung mithin insbesondere eine Gradientenspulenanordnung auf, die mehrere Gradientenspulen, die jeweils einer Hauptrichtung, also Gradientenachse, zugeordnet sind, aufweisen kann, beispielsweise eine X-Gradientenspule, eine Y-Gradientenspule und eine Z-Gradientenspule. Die Steuereinrichtung kann wenigstens einen Prozessor und wenigstens ein Speichermittel umfassen. Zur Realisierung der Schritte des erfindungsgemäßen Verfahrens kann die Steuereinrichtung entsprechende Steuereinheiten aufweisen, beispielsweise eine Ermittlungseinheit zur Ermittlung der Wirbelstromdaten, eine Auswahleinheit zur Wahl des wenigstens einen Pulsparameters und eine allgemeine Sequenzeinheit, die zum Ausspielen der Magnetresonanzsequenz, insbesondere also auch des ersten Spoilergradientenpulses mit dem wenigstens einen gewählten Pulsparameter, ausgebildet ist.

Ein erfindungsgemäßes Computerprogramm ist beispielsweise direkt in einen Speicher einer Speichereinrichtung einer Magnetresonanzeinrichtung ladbar und weist Programmmittel auf, um die Schritte eines erfindungsgemäßen Verfahrens auszuführen, wenn das Computerprogramm in der Steuereinrichtung der Magnetresonanzeinrichtung ausgeführt wird.

Das erfindungsgemäße Computerprogramm kann auf einem erfindungsgemäßen elektronisch lesbaren Datenträger gespeichert sein, welcher mithin darauf gespeicherte elektronisch lesbare Steuerinformationen umfasst, die zumindest ein erfindungsgemäßes Computerprogramm umfassen und derart ausgestaltet ist, dass sie bei Verwendung des Datenträgers in einer Steuereinrichtung einer Magnetresonanzeinrichtung ein erfindungsgemä-βes Verfahren durchführen. Bei dem Datenträger kann es sich insbesondere um einen nichttransienten Datenträger, beispielsweise eine CD-ROM, handeln.

Es sei an dieser Stelle nochmals klarstellend angemerkt, dass der Begriff des Sättigungsmoduls in dem Sinne breit zu verstehen ist, dass die darin enthaltenen Pulse der Sättigung der Spinart dienen, ggf. auch zusammenwirkend mit außerhalb des Sättigungsmoduls liegenden weiteren Pulsen. So sind beispielsweise zur Fettsättigung zwei grundsätzliche chemisch selektive Sättigungstechniken bekannt: Zum einen eine "echte" Fettsättigung mit einem 90°-Sättigungspuls und nachfolgender Dephasierung, zum anderen eine nur auf Fettspins wirkende Inversion (180°), wobei die Anregung der anderen Spinart (hier Wasserspins) beim Nulldurchgang der Magnetisierung der Fettspins erfolgt. Auch im zweiten Fall, für den die SPAIR-Technik ein Beispiel darstellt, werden Spoilergradientenpulse eingesetzt, um alle Magnetisierung, die keinem perfekten 180°-Puls ausgesetzt war, zu dephasieren. Wesentlich ist für das Sättigungsmodul im Rahmen der vorliegenden Erfindung also, dass es einen spektral selektiven Hochfrequenzpuls, den Sättigungspuls, und Spoilergradientenpulse umfasst. Immer dann lässt sich das erfindungsgemäße Vorgehen anwenden.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: den grundsätzlichen Ablauf eines Sättigungsmoduls gemäß dem Stand der Technik,
- Fig. 2: einen Spoilergradientenpuls und den hierdurch entstehenden Wirbelstrom,
- Fig. 3: einen Anteil einer Diffusions-EPI-Sequenz gemäß dem Stand der Technik,
- Fig. 4: den gegenüber Fig. 3 modifizierten Anteil gemäß der vorliegenden Erfindung,
- Fig. 5: Verläufe von Wirbelströmen für die Sequenzdiagramme der Fig. 3 und 4,
- Fig. 6: einen Ablaufplan des erfindungsgemäßen Verfahrens,
- Fig. 7: eine Prinzipskizze einer erfindungsgemäßen Magnetresonanzeinrichtung, und
- Fig. 8: den funktionalen Aufbau einer Steuereinrichtung der Magnetresonanzeinrichtung.

Im Folgenden wird die vorliegende Erfindung anhand einer Diffusions-EPI-Sequenz als Magnetresonanzsequenz näher erläutert werden. Zur Fettsättigung wird ein Sättigungsmodul, das auch ein SPAIR-Modul (SPAIR - Spectral Attenuated Inversion Recovery) sein kann, verwendet.

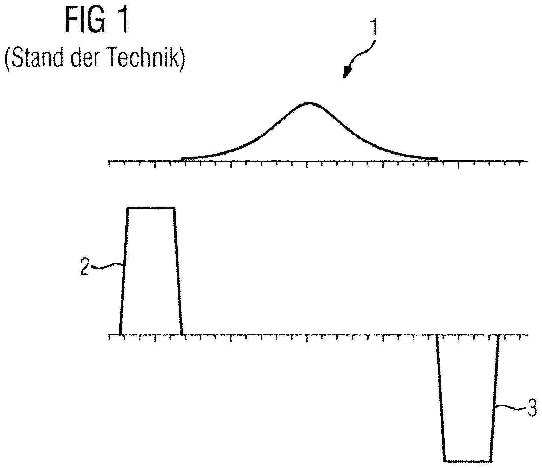

Dabei zeigt Fig. 1 den grundsätzlichen Ablauf eines solchen Sättigungsmoduls. Ein spektral selektiver Hochfrequenz-Sättigungspuls 1 wird zeitlich zwischen zwei Spoilergradientenpulsen 2, 3 ausgegeben. Dabei dient der Spoilergradientenpuls 3 der Dephasierung der Fettspins (bzw. der sonstigen zu sättigenden Spinart) und der erste Spoilergradientenpuls 2 dient der Rephasierung und weist daher üblicherweise dasselbe Moment wie der zweite Spoilergradientenpuls 3 auf.

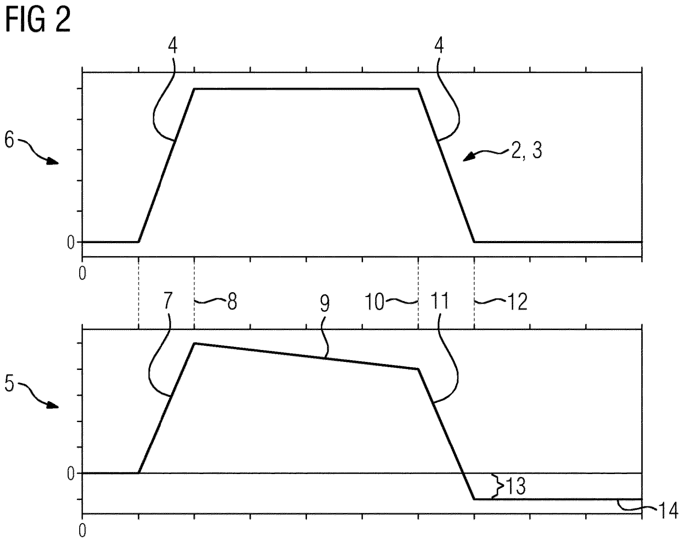

Gradientenpulse erzeugen grundsätzlich Wirbelströme in leitenden Strukturen von Komponenten der Magnetresonanzeinrichtung, wie durch Fig. 2 am Beispiel eines Spoilergradientenpulses 2, 3 erläutert werden soll, der stellvertretend für jeglichen Gradientenpuls steht. Ein Gradientenpuls bedingt durch seine Rampen 4 eine Veränderung des Magnetfeldes, so dass ein Wirbelstrom in leitende Strukturen induziert wird, wie im unteren Graphen 5, der im Zeitablauf dem oberen Graphen 6 entspricht, gezeigt wird. Im Abschnitt 7 baut sich analog zur Rampe 4 ein Wirbelstrom auf. Dieser beginnt ab dem Zeitpunkt 8 exponentiell zu verfallen, vgl. Abschnitt 9, da das Magnetfeld (betrachtet man den Spoilergradientenpuls 2, 3 alleine) gleichbleibt. Aufgrund der hohen Zeitkonstante wirkt der Verlauf im Abschnitt 9 nahezu linear, erfolgt jedoch exponentiell.

Zum Zeitpunkt 10 beginnt die absteigende Rampe des Spoilergradientenpulses 2, 3, so dass ein hier umgekehrter Wirbelstrom induziert wird, wie man im Verlauf des Abschnitts 11 erkennt. Zum Zeitpunkt 12 (Ende des Gradientenpulses 2, 3) liegt mithin ein Restwirbelstrom einer bestimmten Stärke 13 vor, der nun mit der langen Zeitkonstante zu zerfallen beginnt, vgl. Abschnitt 14.

Die Wirbelströme werden in leitenden Strukturen von Komponenten der Magnetresonanzeinrichtung erzeugt. Die Eigenschaften dieser Komponenten bezüglich der Wirbelströme, so dass errechnet bzw. simuliert werden kann, welche Wirbelströme welcher Gradientenpuls einer Magnetresonanzsequenz auslöst, können in einem Kalibrationsvorgang als Komponenteninformation gemessen werden, wofür beispielsweise spezielle Sensoren, nach dem Stand der Technik bekannte magnetresonanzbasierte Verfahren oder dergleichen eingesetzt werden können. Diese Effekte sind nicht merklich vom Patienten abhängig, so dass eine einmalige bzw. in größeren Zeitabständen wiederholte Kalibrierungsmessung zur Ermittlung der Komponenteninformation bezüglich der Wirbelströme ausreichend ist.

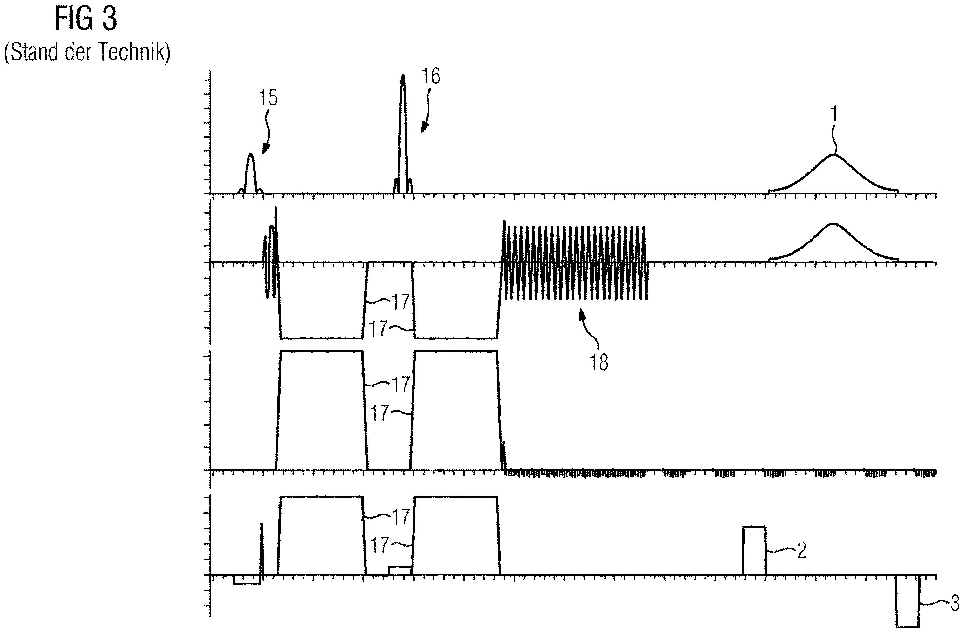

Fig. 3 zeigt einen Anteil eines Sequenzdiagramms einer Diffusions-EPI-Sequenz gemäß dem Stand der Technik. Gezeigt ist das zu Beginn jeder Repetition (hier im Sinne eines neuen Anregungspulses und nicht bezogen auf eine erneute Aufnahme derselben Schicht) zunächst ausgegebene Sättigungsmodul mit dem Sättigungspuls 1 und den Spoilergradientenpulsen 2, 3 im Anschluss an die vorhergehende Repetition. Diese enthält ersichtlich eine Vielzahl weiterer Gradientenpulse, die entsprechenden Hochfrequenzpulsen 15, 16 zeitlich zugeordnet sind. Dabei sind bei einer Diffusions-EPI-Sequenz für die Erzeugung von Wirbelströmen und somit Wirbelstromfeldern besonders die Diffusions-Gradientenpulse 17 sowie mit geringerer Relevanz die häufig schnelle Änderungen der Gradientenfelder bedingenden "Blips" 18 des Auslesezugs verantwortlich, wobei auch andere Gradientenpulse Relevanz sein können, insbesondere auch Spoilergradientenpulse vorangegangener Sättigungsmodule. Es zeigt sich in Untersuchungen, dass als hauptsächlich relevante Ursachen für Wirbelströme mit längeren Zeitkonstanten die Diffusions-Gradientenpulse 17 zu betrachten sind. Wie aus Fig. 3 zu entnehmen ist, werden die Spoilergradientenpulse 2, 3 zum einen nur auf einer Gradientenachse, hier beispielhaft mit der der Z-Richtung zugeordneten Z-Gradientenspule, ausgegeben. Der erste Spoilergradientenpuls 2 hat für diese Diffusionsrichtung die gleiche Polarität für die Diffusions-Gradientenpulse 17, was eher noch zu einer Verstärkung von Wirbelströmen langer Zeitkonstante, die durch die Diffusionsgradientenpulse 17 vorliegen, führt.

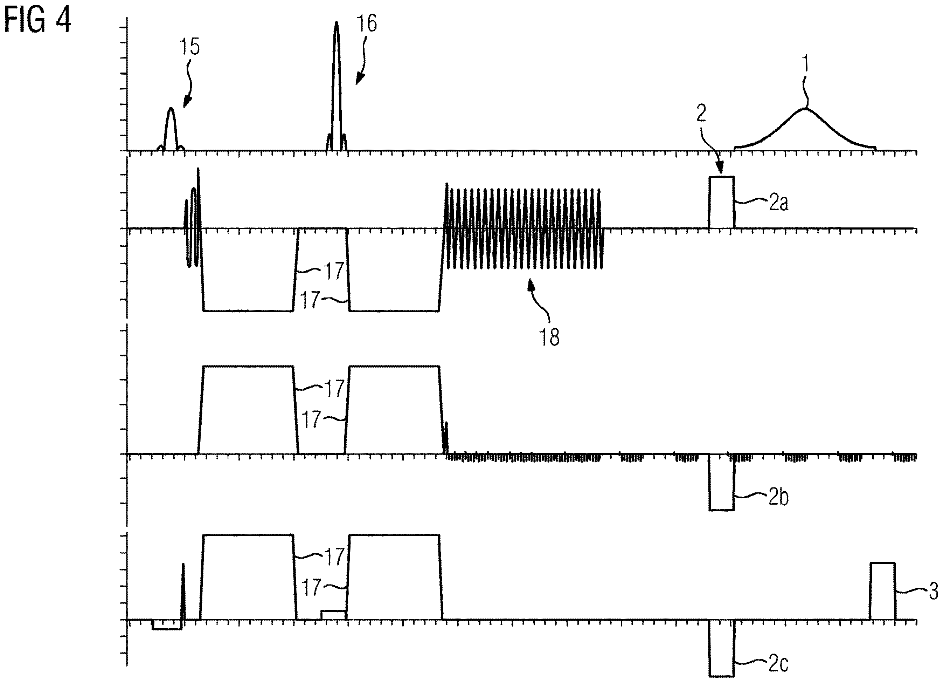

Mithin schlägt die vorliegende Erfindung vor, Pulsparameter des ersten Spoilergradientenpulses 2 so zu wählen, dass die Stärke der Wirbelströme zum Zeitpunkt der Ausgabe des Sättigungspulses 1 möglichst deutlich reduziert werden, so dass es nicht zu Fehlanregungen oder gar überhaupt nicht vorhandenen Anregungen aufgrund von Feldinhomogenitäten kommt. Dabei zeigt Fig. 4 beispielhaft ein erfindungsgemäß modifiziertes Sequenzdiagramm, das dem in Fig. 3 entspricht. Das Ende der vorherigen Repetition mit den Pulsen 15 bis 18 bleibt unverändert. Für den ersten Spoilergradientenpuls 1 wurden nun jedoch die zu verwendenden Gradientenachsen - hier alle drei -, Polaritäten und die Amplituden bzw. deren Verteilung auf die Gradientenachsen so gewählt, dass die Wirbelströme zum Zeitpunkt der Ausgabe des Sättigungspulses 1 deutlich reduziert sind. Mithin enthält der Spoilergradientenpuls 1 nun drei Teilpulse 2a, 2b und 2c für die verschiedenen Gradientenachsen, für die zu erkennen ist, dass deren Polarität jeweils der umgekehrten Polarität der Diffusionsgradientenpulse 17 der jeweiligen Achsen entspricht. Ferner liegt auch eine entsprechende Anpassung und Verteilung der Amplituden vor, um die qualitativ deutliche Verringerung der Wirbelströme durch Kompensation mittels des modifizierten ersten Spoilergradientenpulses 2 zu erreichen.

Dabei sei bereits an dieser Stelle darauf hingewiesen, dass die Abschätzung von Wirbelstromdaten, die die von den weiteren Gradientenpulsen 17, 18 erzeugten Wirbelströme zur Zeit des Sättigungsmoduls beschreiben sowie die Ermittlung angepasster Pulsparameter des ersten Spoilergradientenpulses 2 aufgrund der bekannten Komponenteninformation und der auch im Voraus bekannten Sequenzdaten, die die auszugebenden Gradientenpulse beschreiben, bereits im Voraus möglich ist, was es im Übrigen auch ermöglicht, bei einem stark durch die Anpassung der Pulsparameter geänderten Moment des Spoilergradientenpulses 2 das Dephasierungsmoment des vorangehenden zweiten Spoilergradientenpulses 3 entsprechend anzupassen, so dass sich eine entsprechende Rephasierung ergibt.

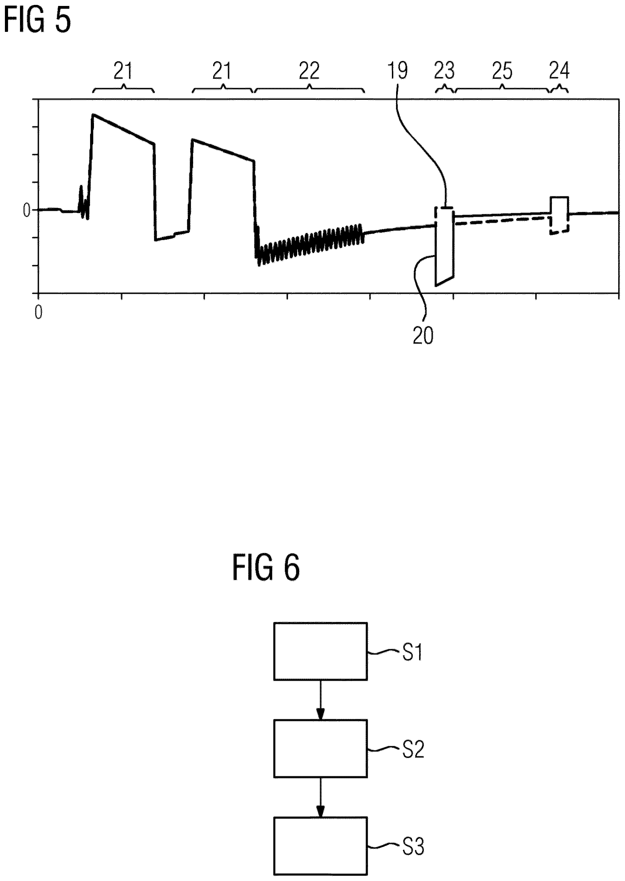

Fig. 5 zeigt für die Sequenzdiagramme der Fig. 3 und 4 jeweils qualitativ den Wirbelstromverlauf. Die gestrichelte Kurve 19 zeigt dabei den Verlauf für einen nicht angepassten ersten Spoilergradientenpuls 2 gemäß Fig. 3. Dieser überlagert ist die durchgezogene Kurve 20 gezeigt, die bei der vorgenommenen Wahl der Pulsparameter gemäß Fig. 4 gegeben ist. Deutlich zu erkennen sind die Zeiträume 21 der Diffusionsgradientenpulse 17 sowie der Zeitraum 22 der "Blips" 18. Ebenso ist zu erkennen, dass in den Zeiträumen 23 und 24 der erste Spoilergradientenpuls 2 bzw. der zweite Spoilergradientenpuls 3 ausgegeben werden. Der relevante Zeitraum 25, in dem der Sättigungspuls 1 ausgegeben wird, liegt zwischen den Zeiträumen 23 und 24. Wie sich aus den Kurven 19 und 20 ergibt, sind die Wirbelströme bei Anpassung der Pulsparameter im Zeitraum 25 um mehr als die Hälfte reduziert, ohne dass die Wirbelströme außerhalb des Sättigungsmoduls nennenswert verstärkt werden.

Fig. 6 zeigt nun einen Ablaufplan des erfindungsgemäßen Verfahrens. Dabei wird in einem Schritt S1, insbesondere bereits vor Beginn der Untersuchung unter Verwendung der Diffusions-EPI-Sequenz für jedes auszugebende Sättigungsmodul vorausberechnet, welche Wirbelströme zum Zeitpunkt der Ausgabe des Sättigungspulses 1 vorliegen. Hierbei kann über einen mathematischen Zusammenhang und/oder eine Simulation ausgehend von den Sequenzdaten und der bereits genannten Komponenteninformation gearbeitet werden.

In dem Schritt S2 werden die Wirbelstromdaten und wiederum die Komponenteninformation genutzt, um die Pulsparameter für den ersten Spoilergradientenpuls 2 jedes Sättigungsmoduls zu ermitteln. Dies kann, nachdem es um eine qualitative Reduzierung geht, wiederum anhand eines vereinfachten Zusammenhangs geschehen, aber auch in einem etwas komplexeren Optimierungsverfahren. In jedem Fall werden im Schritt S2 jedoch Randbedingungen betrachtet. Dabei sind zunächst Limitationen zu nennen. Zum einen sind durch das Gradientensystem der Gradientenspulenanordnung gewisse Einschränkungen bezüglich der maximalen Amplitude, der maximalen Slew Rate und eine Leistungsbeschränkung vorhanden, die berücksichtigt werden. Ferner soll der Spoilergradientenpuls 3 die Fettspins dephasieren, so dass ein minimales Gesamtmoment vorgegeben werden kann.

Durch die Modifikation der Pulsparameter, wobei im Übrigen vorliegend die Amplitude, die Polarität und die verwendeten Gradientenachsen, insbesondere auch die Verteilung der Amplituden auf die Gradientenachsen, verwendet werden, für jedes Sättigungsmodul kann es weiterhin vorkommen, dass der erste Spoilergradientenpuls 2 nicht mehr in notwendiger Weise den dephasierenden zweiten Spoilergradientenpuls des vorherigen Sättigungsmoduls rephasiert. Während für viele Situationen dies die Bildqualität nicht signifikant beeinflusst, können dennoch Fälle existieren, in denen als zusätzliche Randbedingung eine möglichst vollständige Rephasierung eingeführt wird.

Dabei sei darauf hingewiesen, dass es alternativ oder zusätzlich jedoch auch denkbar ist, nachdem die Berechnung ja vor der eigentlichen Untersuchung erfolgt, den zweiten Spoilergradientenpuls des vorangehenden Sättigungsmoduls entsprechend auf das angepasste Moment des ersten Spoilergradientenpulses 2 des folgenden Sättigungsmoduls anzupassen, vgl. optionaler Schritt S3, solange das minimale Gesamtmoment zur Dephasierung erhalten bleibt.

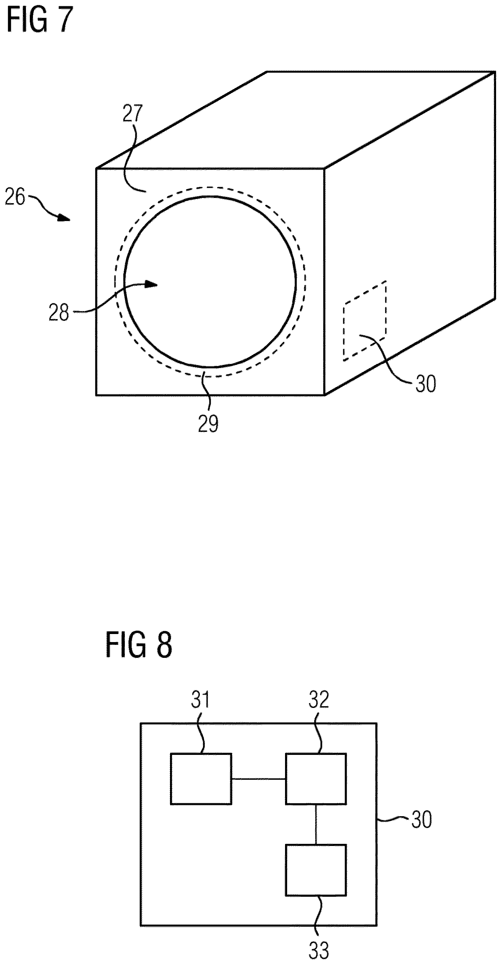

Fig. 7 zeigt eine Prinzipskizze einer erfindungsgemäßen Magnetresonanzeinrichtung 26. Diese weist, wie grundsätzlich bekannt, eine Hauptmagneteinheit 27 auf, die eine Patientenaufnahme 28 definiert, in die ein Patient mittels einer hier nicht näher gezeigten Patientenliege eingefahren werden. Die Patientenaufnahme 28 umgebend sind eine hier nicht näher gezeigte Hochfrequenzspulenanordnung und eine Gradientenspulenanordnung 29 vorgesehen.

Die Gradientenspulenanordnung 29 weist dabei drei jeweils einer Gradientenachse zugeordnete Gradientenspulen, hier eine X-Gradientenspule, eine Y-Gradientenspule und eine Z-Gradientenspule, auf. Die Gradientenspulen erzeugen mithin ein Gradientenfeld, welches einen Gradienten entlang der jeweiligen Gradientenachse aufweist. Die Gradientenachsen X, Y, Z werden häufig auch als Hauptrichtungen bezeichnet.

Der Betrieb der Magnetresonanzeinrichtung 26 wird durch eine Steuereinheit 30 gesteuert, die auch zur Durchführung des erfindungsgemäßen Verfahrens ausgebildet ist.

Gemäß Fig. 8 weist die Steuereinrichtung 30 dazu wenigstens eine Ermittlungseinheit 31 zur Ermittlung der Wirbelstromdaten, eine Auswahleinheit 32 zur Wahl der Pulsparameter und eine Sequenzeinheit 33 auf, die wie grundsätzlich bekannt den Ablauf der Magnetresonanzsequenz steuert, vorliegend mithin für die Ausgabe der ersten Spoilergradientenpulse 2 mit den entsprechend gewählten Pulsparametern sorgt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, welcher durch die Ansprüche definiert ist.

## Patentansprüche

1. Verfahren zum Betrieb einer Magnetresonanzeinrichtung (26) bei der Aufnahme von Magnetresonanzdaten mittels einer Magnetresonanzsequenz, die wenigstens ein Sättigungsmodul für eine zu sättigende Spinart, in dem ein Hochfrequenz-Sättigungspuls (1) zwischen einem ersten und einem zweiten Spoilergradientenpuls (2, 3) ausgegeben wird, und neben den Spoilergradientenpulsen (2, 3) mehrere weitere Gradientenpulse umfasst, wobei
- während der Ausgabe des Sättigungspulses (1) vorliegende Wirbelströme aufgrund der weiteren Gradientenpulse beschreibende Wirbelstromdaten ermittelt werden,
- in Abhängigkeit der Wirbelstromdaten wenigstens ein Pulsparameter des ersten Spoilergradientenpulses (2) derart gewählt wird, dass die mittels des ersten Spoilergradientenpulses (2) erzeugten Wirbelströme wenigstens einen Teil der durch die Wirbelstromdaten beschriebenen Wirbelströme wenigstens während der Ausgabe des Sättigungspulses (1) kompensieren, und
- der erste Spoilergradientenpuls (2) mit dem wenigstens einen gewählten Pulsparameter ausgegeben wird, **dadurch gekennzeichnet, dass**
in Abhängigkeit des gewählten Pulsparameters des ersten Spoilergradientenpulses (2) auch wenigstens ein Pulsparameter des zweiten Spoilergradientenpulses (3) eines vorangehenden Sättigungsmoduls angepasst wird.

2. Verfahren nach Anspruch 1, **dadurch gekennzeichnet, dass** der Pulsparameter des ersten Spoilergradientenpulses
aus der Gruppe umfassend die Pulsform bestimmende Pulsparameter, die Polarität und die verwendeten Gradientenrichtungen gewählt wird.

3. Verfahren nach Anspruch 1 oder 2, **dadurch gekennzeichnet, dass** die weiteren Gradientenpulse wenigstens einen Diffusionsgradientenpuls (17) in einem Diffusionsmodul der Magnetresonanzsequenz umfassen und/oder die Magnetresonanzsequenz eine EPI-Sequenz ist.

4. Verfahren nach Anspruch 3, wobei die weiteren Gradientenpulse wenigstens einen Diffusionsgradientenpuls (17) in einem Diffusionsmodul der Magnetresonanzsequenz umfassen,
**dadurch gekennzeichnet, dass**
als Pulsparameter des ersten Spoilergradientenpulses die Polarität des ersten Spoilergradientenpulses (2) des dem Diffusionsmodul nachfolgenden Sättigungsmoduls umgekehrt zu der des wenigstens einen Diffusionsgradientenpulses (17) gewählt wird.

5. Verfahren nach einem der vorangehenden Ansprüche, **dadurch gekennzeichnet, dass** die Wirbelstromdaten im Rahmen einer Simulation und/oder unter Verwendung eines mathematischen Zusammenhangs und/oder unter Berücksichtigung vorbekannter, die weiteren Gradientenpulse beschreibender Sequenzdaten und/oder unter Berücksichtigung wenigstens einer wenigstens eine Eigenschaft wenigstens einer Komponente der Magnetresonanzeinrichtung (26) bezüglich durch Gradientenpulse induzierter Wirbelströme beschreibenden Komponenteninformation ermittelt werden.

6. Verfahren nach Anspruch 5, **dadurch gekennzeichnet, dass** die Komponenteninformation in einem Kalibrierungsvorgang durch Messung mit vordefinierten Kalibrierungsgradientenpulsen ermittelt wird.

7. Verfahren nach Anspruch 5 oder 6, **dadurch gekennzeichnet, dass** die Komponenteninformation wenigstens eine die Stärke induzierter Wirbelströme beschreibende Stärkegröße und/oder wenigstens eine den Zerfall der Wirbelströme beschreibende Zeitkonstante umfasst.

8. Verfahren nach einem der vorangehenden Ansprüche, **dadurch gekennzeichnet, dass** die Ermittlung des wenigstens einen Pulsparameters des ersten Spoilergradientenpulses in einem auf die Minimierung verbleibender Wirbelströme abzielenden Optimierungsverfahren und/oder aufgrund wenigstens eines mathematischen Zusammenhangs und/oder unter Verwendung wenigstens einer Randbedingung erfolgt.

9. Verfahren nach Anspruch 8, **dadurch gekennzeichnet, dass** als Randbedingung wenigstens ein minimales Gesamtmoment des ersten Spoilergradientenpulses (2) und/oder eine maximale Amplitude des ersten Spoilergradientenpulses (2) und/oder eine maximale Slew Rate des ersten Spoilergradientenpulses (2) verwendet wird.

10. Verfahren nach Anspruch 8 oder 9, **dadurch gekennzeichnet, dass** als weiteres, insbesondere geringer gewichtetes Optimierungsziel und/oder als Randbedingung eine möglichst weitgehende Rephasierung von durch den zweiten Spoilergradientenpuls (3) eines vorangehenden Sättigungsmoduls dephasierten Spins der zu sättigenden Spinart verwendet wird.

11. Verfahren nach einem der vorhergehenden Ansprüche, **dadurch gekennzeichnet, dass** bei einem durch den gewählten Pulsparameter des ersten Spoilergradientenpulses (2) von einem Vorgabemoment abweichenden Rephasierungsmoment der Pulsparameter des zweiten Spoilergradientenpulses (3) des vorangehenden Sättigungsmoduls zur Erzeugung eines dem Rephasierungsmoment entsprechenden Dephasierungsmoments angepasst wird.

12. Magnetresonanzeinrichtung (26), aufweisend eine zur Durchführung eines Verfahrens nach einem der vorangehenden Ansprüche ausgebildete Steuereinrichtung (30).

13. Computerprogramm, welche die Schritte eines Verfahrens nach einem der Ansprüche 1 bis 11 durchführt, wenn es auf einer Steuereinrichtung (30) einer Magnetresonanzeinrichtung (26) ausgeführt wird.

14. Elektronisch lesbarer Datenträger, auf dem ein Computerprogramm nach Anspruch 13 gespeichert ist.

## Claims

1. Method for operating a magnetic resonance facility (26) during recording of magnetic resonance data by using a magnetic resonance sequence, which comprises at least one saturation module for a spin type to be saturated, in which a high-frequency saturation pulse (1) is emitted between a first and a second spoiler gradient pulse (2, 3), and multiple further gradient pulses apart from the spoiler gradient pulses (2, 3), wherein
- eddy current data is determined, which describes eddy currents which exist during emission of the saturation pulse (1) and are a result of the further gradient pulses,
- at least one pulse parameter of the first spoiler gradient pulse (2) is selected depending on the eddy current data such that the eddy currents generated by way of the first spoiler gradient pulse (2) compensate for at least part of the eddy currents described by the eddy current data at least during emission of the saturation pulse (1), and
- the first spoiler gradient pulse (2) is emitted with the at least one selected pulse parameter, **characterised in that** as a function of the pulse parameter selected for the first spoiler gradient pulse (2), at least one pulse parameter of the second spoiler gradient pulse (3) of a preceding saturation module is also adjusted.

2. Method according to claim 1, **characterised in that** the pulse parameter of the first spoiler gradient pulse is selected from the group comprising pulse parameters determining the pulse shape, the polarity, and the gradient directions used.

3. Method according to claim 1 or 2, **characterised in that** the further gradient pulses comprise at least one diffusion gradient pulse (17) in a diffusion module of the magnetic resonance sequence and/or the magnetic resonance sequence is an EPI sequence.

4. Method according to claim 3, wherein the further gradient pulses comprise at least one diffusion gradient pulse (17) in a diffusion module of the magnetic resonance sequence, **characterised in that** as a pulse parameter of the first spoiler gradient pulse, the polarity of the first spoiler gradient pulse (2) of the saturation module following the diffusion module is selected opposite to that of the at least one diffusion gradient pulse (17).

5. Method according to one of the foregoing claims, **characterised in that** the eddy current data is determined in the context of a simulation and/or by using a mathematical relation and/or by taking account of already known sequence data describing the further gradient pulses and/or by taking account of at least one item of component information describing at least one property of at least one component of the magnetic resonance facility (26) with reference to eddy currents induced by gradient pulses.

6. Method according to claim 5, **characterised in that** the item of component information is determined in a calibration operation by measuring with predefined calibration gradient pulses.

7. Method according to claim 5 or 6, **characterised in that** the item of component information comprises at least one strength variable describing the strength of induced eddy currents and/or at least one time constant describing the decay of the eddy currents.

8. Method according to one of the foregoing claims, **characterised in that** the determination of the at least one pulse parameter of the first spoiler gradient pulse is effected in an optimisation method aimed at minimising residual eddy currents and/or on the basis of at least one mathematical relation and/or by using at least one boundary condition.

9. Method according to claim 8, **characterised in that** at least one minimum overall moment of the first spoiler gradient pulse (2) and/or a maximum amplitude of the first spoiler gradient pulse (2), and/or a maximum slew rate of the first spoiler gradient pulse (2) is used as a boundary condition.

10. Method according to claim 8 or 9, **characterised in that** the most extensive possible rephasing of spins of the spin type to be saturated, that are dephased by the second spoiler gradient pulse (3) of a preceding saturation module, is used as a further, in particular lower weighted optimisation aim, and/or as a boundary condition.

11. Method according to one of the foregoing claims, **characterised in that** in the event of a rephasing moment diverging from a specified moment due to the selected pulse parameter of the first spoiler gradient pulse (2), the pulse parameter of the second spoiler gradient pulse (3) of the preceding saturation module is adjusted to generate a dephasing moment corresponding to the rephasing moment.

12. Magnetic resonance facility (26), having a control facility (30) realised for carrying out a method according to one of the foregoing claims.

13. Computer program which carries out the steps of a method according to one of claims 1 to 11 when it is executed on a control facility (30) of a magnetic resonance facility (26).

14. Electronically readable data carrier on which a computer program according to claim 13 is stored.

## Revendications

1. Procédé pour faire fonctionner un dispositif (26) de résonnance magnétique, lors de l'enregistrement de données de résonnance magnétique au moyen d'une séquence de résonnance magnétique, qui comprend au moins un module de saturation pour un type de spin à saturer, dans lequel on émet une impulsion (1) de saturation en haute fréquence entre une première et une deuxième impulsion (2, 3) à gradient spoiler, et, outre les impulsions (2, 3) à grandient spoiler, plusieurs autres impulsions à gradient, dans lequel
- on détermine des courants de Foucault présents pendant l'émission de l'impulsion (1) de saturation sur la base de données de courant de Foucault décrivant d'autres impulsions à gradient,
- en fonction des données de courants de Foucault, on sélectionne au moins un paramètre d'impulsion de la première impulsion (2) à gradient spoiler, de manière à ce que les courants de Foucault, produits au moyen de la première impulsion (2) à gradient spoiler, compensent, au moins pendant l'émission de l'impulsion (1) de saturation, au moins une partie des courants de Foucault décrits par les données de courants de Foucault, et
- on émet la première impulsion (2) à gradient spoiler ayant le au moins un paramètre d'impulsion sélectionné, **caractérisé en ce que**
en fonction du paramètre d'impulsion sélectionné de la première impulsion (2) à gradient spoiler, on adapte également au moins un paramètre d'impulsion de la deuxième impulsion (3) à gradient spoiler d'un module de saturation précédent.

2. Procédé suivant la revendication 1, **caractérisé en ce que** l'on sélectionne le paramètre d'impulsion de la première impulsion à gradient spoiler dans le groupe comprenant le paramètre d'impulsion déterminant la forme de l'impulsion, la polarité et les directions de gradient utilisées.

3. Procédé suivant la revendication 1 ou 2, **caractérisé en ce que** les autres impulsions à gradient comprennent au moins une impulsion (17) à gradient de diffusion dans un module de la diffusion de la séquence de résonnance magnétique et/ou la séquence de résonnance magnétique est une séquence EPI.

4. Procédé suivant la revendication 3, dans lequel les autres impulsions à gradient comprennent une impulsion (17) à gradient de diffusion dans un module de diffusion de la séquence de résonnance magnétique,
**caractérisé en ce que**
l'on sélectionne, comme paramètre d'impulsion de la première impulsion à gradient spoiler, la polarité de la première impulsion (2) à gradient spoiler du module de saturation suivant le module de diffusion inverse de celle de la au moins une impulsion (17) à gradient de diffusion.

5. Procédé suivant l'une des revendications précédentes, **caractérisé en ce que** l'on détermine les données de courants de Foucault dans le cadre d'une simulation et/ou en utilisant une relation mathématique et/ou en tenant compte de données de séquence connues à l'avance, décrivant les autres impulsions à gradient et/ou en tenant compte d'au moins une information de composant décrivant une propriété d'au moins un composant du dispositif (26) de résonnance magnétique en ce qui concerne des courants de Foucault induits par des impulsions à gradient.

6. Procédé suivant la revendication 5, **caractérisé en ce que** l'on détermine l'information de composants dans une opération d'étalonnage par mesure d'impulsions à gradient d'étalonnage définies à l'avance.

7. Procédé suivant la revendication 5 ou 6, **caractérisé en ce que** l'information de composants comprend au moins une grandeur d'intensité décrivant l'intensité des courants de Foucault induits et/ou au moins une constante de temps décrivant une disparition des courants de Foucault.

8. Procédé suivant l'une des revendications précédentes, **caractérisé en ce que** la détermination du au moins un paramètre d'impulsion de la première impulsion à gradient spoiler s'effectue dans un procédé d'optimisation visant la minimisation de courants de Foucault restants et/ou sur la base d'au moins une relation mathématique et/ou en utilisant au moins une condition aux limites.

9. Procédé suivant la revendication 8, **caractérisé en ce que** l'on utilise comme condition aux limites au moins un moment d'ensemble minimum de la première impulsion (2) à gradient spoiler et/ou une amplitude maximum de la première impulsion (2) à gradient spoiler et/ou un slew rate maximum de la première impulsion (2) à gradient spoiler.

10. Procédé suivant la revendication 8 ou 9, **caractérisé en ce que** l'on utilise comme autre cible d'optimisation, en particulier moins pondérée, et/ou comme condition aux limites, un rephasage aussi poussé que possible de spins déphasés, par la deuxième impulsion (3) à gradient spoiler d'un module de saturation précédent, du type de spin à saturer.

11. Procédé suivant l'une des revendications précédentes, **caractérisé en ce que**, si un moment de rephasage s'écarte d'un moment prescrit par le paramètre d'impulsion sélectionné de la première impulsion (2) à gradient spoiler, on adapte le paramètre d'impulsion de la deuxième impulsion (3) à gradient spoiler du module de saturation précédent, pour la production d'un moment de déphasage correspondant au moment de rephasage.

12. Dispositif (26) de résonnance magnétique comportant un dispositif (30) de commande constitué pour l'exécution d'un procédé suivant l'une des revendications précédentes.

13. Programme d'ordinateur, qui effectue les stades d'un procédé suivant l'une des revendications 1 à 11, lorsqu'il est exécuté sur un dispositif (30) de commande d'un dispositif (26) de résonnance magnétique.

14. Support de données, déchiffrable électroniquement, sur lequel est mis en mémoire un programme d'ordinateur suivant la revendication 13.
